(19) Europäisches Patentamt
European Patent Office
Office européen des brevets

(11) Veröffentlichungsnummer: **0 307 353 A2**

# (12) EUROPÄISCHE PATENTANMELDUNG

(21) Anmeldenummer: **88810579.8**

(22) Anmeldetag: **23.08.88**

(51) Int. Cl.[4]: **C 08 F 30/04**
C 08 F 8/42, G 03 F 7/10
// C07F7/00

(30) Priorität: **07.09.87 CH 3426/87**

(43) Veröffentlichungstag der Anmeldung:
**15.03.89 Patentblatt 89/11**

(84) Benannte Vertragsstaaten:
**AT CH DE FR GB IT LI NL SE**

(71) Anmelder: **CIBA-GEIGY AG**
**Klybeckstrasse 141**
**CH-4002 Basel (CH)**

(72) Erfinder: **Steinmann, Alfred, Dr.**
**Les Russilles**
**CH-1724 Praroman (CH)**

## (54) Organometallhaltige Polymere und deren Verwendung.

(57) Organometallhaltige Polymere mit Seitenketten der Formel I

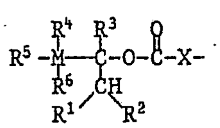

(I) ,

worin zum Beispiel M Si, X O, $R^1$ und $R^2$ Wasserstoff und $R^4$ bis $R^6$ je Methyl bedeuten und ein mittleres Molekulargewicht zwischen 1000 und 1'000'000 aufweisen, eignen sich zur Herstellung von trockenentwickelbaren Photoresists, wie sie bei der Erzeugung von strukturierten Bildern, insbesondere in der Mikroelektronik, benötigt werden.

EP 0 307 353 A2

**Beschreibung**

**Organometallhaltige Polymere und deren Verwendung**

Die Erfindung betrifft neue organometallhaltige Polymere, strahlungssensitive, trockenentwickelbare, sauerstoffplasmaresistente Zusammensetzungen enthaltend diese Verbindungen sowie deren Verwendung zur Erzeugung von strukturierten Positivbildern.

Unter selbst- oder trockenentwickelbaren Zusammensetzungen (Resists) versteht man eine Klasse von Verbindungen, welche nach Bestrahlung in flüchtige Teilchen zerfällt, oder welche nach der Bestrahlung mit einem Plasma strukturiert werden können, ohne dass eine Nass-Entwicklung zur Bilderzeugung notwendig ist. Verschiedene Materialien wurden für diesen Zweck vorgeschlagen, so z.B. Polymethylmethacrylat, Polyethylenterephthalat, Nitrocellulose oder Polyisopren [s. beispielsweise H. Franke, Appl. Phys. Lett. 45(1), 110 ff (1984)]. Bei der Verwendung solcher Materialien treten häufig verschiedene Nachteile auf, wie niedrige Empfindlichkeit, mangelhafte Stabilität, Bildung von nichtflüchtigen Rückständen, mangelnde Resistenz gegen Sauerstoffplasma, oder mangelnde Auflösung.

Die US 4,491,628 beschreibt Resist-Stoffgemische enthaltend ein Polymer mit säureunbeständigen Seitengruppen, wie z.B. tert.-Butylester- oder tert.-Butylcarbonatgruppen, und einen Photoinitiator, der bei Bestrahlung Säure generiert. Als Polymere werden vorzugsweise Vinylpolymere, wie Polystyrol oder Polyacrylat, eingesetzt, während als Photoinitiatoren vor allem Oniumsalze, z.B. Diaryliodonium- oder Triarylsulfoniumsalze, verwendet werden. In den belichteten Stellen wird Säure generiert, die säureunbeständigen Gruppen werden abgespalten und die Polarität des Polymeres wird dadurch verändert. Durch die Wahl eines geeigneten polaren oder unpolaren Lösungsmittels für die Bildentwicklung können mit diesem Photoresist sowohl Positiv- als auch Negativbilder erzeugt werden.

Für viele Anwendungen, insbesondere in der Mikroelektronik, hat die Verwendung von nass-entwickelbaren Resists einige Nachteile zur Folge; zusätzliche Prozessschritte, Kontaminationsgefahr durch die Lösungsmittel, Entsorgungsprobleme etc. Daher werden trockenentwickelbare Zusammensetzungen bevorzugt.

In der EP-A 178 208 und in Microcircuit Engineering, 471-481 (1985) werden Polystyrole mit siliciumhaltigen Seitengruppen beschrieben, die sich zusammen mit bestimmten Photoinitiatoren als trockenentwickelbare positive Resists eignen. Dabei werden in den bestrahlten Stellen des Resistfilms Trialkylsilylgruppen, welche über Ethersauerstoffatome oder Aminstickstoffatome an die Polystyrolkette gebunden sind, abgespalten. Somit können mittels Plasmaentwicklung die bestrahlten Stellen des Films entfernt werden, während die nicht bestrahlten, siliciumhaltigen Bereiche des Films plasmaresistent sind. Der Nachteil dieses Systems liegt in der relativ hohen Lichtdosis von 80-120 $mJ/cm^2$, die für die Bilderzeugung benötigt wird, wie auch in der ungenügenden Löslichkeit des Polymers in geeigneten Lösungsmitteln. Auch die Flüchtigkeit der bei der Bestrahlung abgespaltenen siliciumhaltigen Verbindungen ist nicht immer zufriedenstellend.

Die US 4,443,044 beschreibt siliciumhaltige Oximester der Methacrylsäure, deren Polymere ebenfalls als trocken entwickelbare, im kurzwelligen UV-Bereich empfindliche Positivresists eingesetzt werden können. Dabei sind Trimethylsilylgruppen über Methylenbrücken direkt an den Benzolring des Acetophenonoximrests der Polymer-seitenketten gebunden. Dieses System bedarf aber einer sehr hohen Lichtdosis von 1000-4500 $mJ/cm^2$, um eine genügende Abspaltung des siliciumhaltigen Rests zu erreichen. Zudem muss das System vor dem Plasmaätzvorgang bei erhöhter Temperatur im Hochvakuum erhitzt werden, um eine gute Bildstruktur zu erhalten.

Es wurde nun eine Klasse organometallhaltiger Polymere gefunden, welche im Gemisch mit katalytischen Mengen bestimmter Photoinitiatoren eine sehr hohe Strahlungsempfindlichkeit aufweisen. Zudem zeichnen sich diese Polymere durch eine hohe Sauerstoffplasmaresistenz auf. Falls zweckmässig, können die bestrahlten Polymere auch nass entwickelt werden, wobei je nach Polarität des verwendeten Entwicklers sowohl Positiv- als auch Negativbilder erzeugt werden können. Die bei der Bestrahlung freigesetzten, von den Polymerseitenketten abgespaltenen Verbindungen sind zudem leicht flüchtig, so dass für die Trockenentwicklung keine sehr hohe Temperaturen oder gar Hochvakuum nötig sind.

Gegenstand der Erfindung sind organometallhaltige Polymer mit Gruppierungen der Formel I

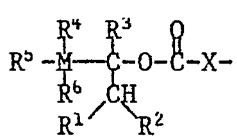

(I) ,

worin $R^1$ bis $R^6$ unabhängig voneinander $C_1$-$C_4$-Alkyl, Phenyl, Benzyl, Phenoxy, eine Gruppe $-M(R^8)_3$ oder

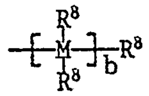

bedeuten oder $R^3$ und $R^4$ zuzammen für

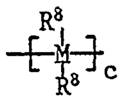

stehen und $R^1$ bis $R^3$ zusätzlich auch Wasserstoffatome sein können, $R^8$ $C_1$-$C_4$-Alkyl, $C_1$-$C_4$-Alkoxy, Phenyl, Benzyl oder Phenoxy ist, M für Si, Ge, Sn, $CH_2Si$ oder OSi und X für O, S oder NR′ mit R′ gleich Wasserstoff oder einfache Bindung stehen, b eine ganze Zahl von 1 bis 6 und c eine ganze Zahl von 3 bis 6 bedeuten, und einem mittleren Molekulargewicht zwischen 1000 und 1'000'000.

Vorzugsweise sind die Gruppierungen der Formel I an ein Polystyrolpolymer gebunden, so dass die erfindungsgemässen Polymere wiederkehrende Einheiten der Formel II enthalten

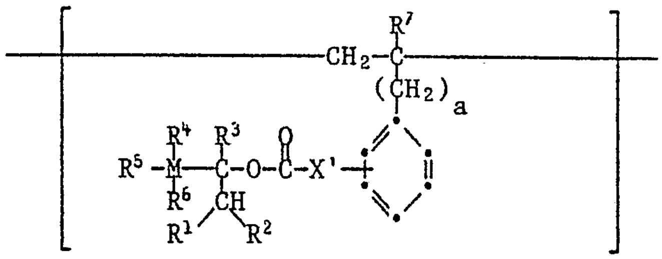

(II) ,

worin $R^1$ bis $R^6$ und M die oben angegebene Bedeutung haben, X′ für O, S oder NH steht, $R^7$ Wasserstoff oder $C_1$-$C_4$-Alkyl und a Null oder 1 bedeuten.

Die $C_1$-$C_4$-Alkylgruppen, bzw. die Alkylreste der $C_1$-$C_4$-Alkoxygruppen der Reste $R^1$ bis $R^8$ der erfindungsgemässen Verbindungen können verzweigt oder vorzugsweise geradkettig sein und sind z.B. n-, iso-, sec.- oder tert.-Butyl, n- oder iso-Propyl, Ethyl und insbesondere Methyl.

Besonders bevorzugte erfindungsgemässe Verbindungen sind Siliciumverbindungen, wobei M $CH_2Si$, OSi oder insbesondere Si bedeutet. Ebenso bevorzugt sind erfindungsgemässe Verbindungen, worin X S oder insbesondere O bedeutet.

Die organometallhaltigen Gruppierungen der Formel I der erfindungsgemässen Polymere enthalten definitionsgemäss mindestens ein Silicium-, Germanium- oder Zinnatom M, können aber auch zwei oder mehrere dieser Atome aufweisen. Wenn die Substituenten $R^3$ und $R^4$ zusammen einen zweiwertigen Rest

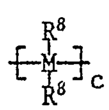

bedeuten, bilden die Gruppierungen einen Ring, der z.B. ein Kohlenstoffatom und mehrere Metallatome enthält. Dabei sind Verbindungen mit fünf- und sechsgliedrigen Ringen bevorzugt. Bevorzugt sind auch erfindungsgemässe Verbindungen, worin die Reste $R^4$, $R^5$ und $R^6$ gleich sind.

Im allgemeinen werden diejenigen erfindungsgemässen Polymere bevorzugt, welche bei Bestrahlung in Anwesenheit eines säurefreisetzenden Photoinitiators neben $CO_2$ eine möglichst leichtflüchtige Verbindung

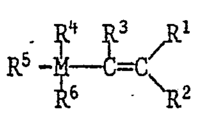

abspalten.

Es versteht sich von selbst, dass dieses Ziel durch geeignete Kombinationen der Substituenten $R^1$ bis $R^6$ und des Metallatoms M erreicht wird.

Wenn einer der Reste $R^1$ bis $R^6$ der erfindungsgemässen Verbindungen für

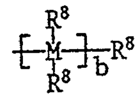

steht, bedeutet b vorzugsweise eine ganze Zahl von 1 bis 3, insbesondere 1.

Bevorzugt werden auch erfindungsgemässe Polymere, worin $R^1$ und $R^2$ je Wasserstoff, $R^3$ Methyl oder $Si(CH_3)_3$ und $R^4$ bis $R^6$ je Methyl bedeuten oder worin $R^3$ und $R^4$ zusammen für

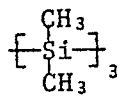 oder 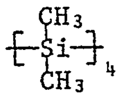

stehen.

Besonders bevorzugt sind Polymere, worin $R^1$ und $R^2$ je Wasserstoff, $R^3$ Methyl oder $Si(CH_3)_3$, $R^4$ bis $R^6$ je Methyl, M Si und X O bedeuten. Bevorzugt werden zudem Verbindungen mit wiederkehrenden Einheiten der Formel II, worin a Null und $R^7$ Wasserstoff oder Methyl bedeuten.

Die erfindungsgemässen Polymere besitzen vorzugsweise ein mittleres Molekulargewicht von 10000 bis 500000 und insbesondere von 25000 bis 100000.

Bei den erfindungsgemässen Polymeren mit wiederkehrenden Einheiten der Formel II handelt es sich vorzugsweise um Homopolymere. Als strahungssensitive, trockenentwickelbare Zusammensetzung eignen sich aber auch Copolymere, so z.B. Copolymere, welche aus zwei oder mehr Bausteinen der Formel II verschiedener Struktur aufgebaut sind oder Copolymere, welche neben Struktureinheiten der Formel II andere Bausteine enthalten, welche sich von copolymerisierbaren Monomeren ableiten. Die vorliegende Erfindung betrifft daher auch organometallhaltige Copolymere, enthaltend das wiederkehrende Strukturelement der Formel II und bis zu 50 Mol-%, bezogen auf das gesamte Copolymer, Struktureinheiten, welche sich von anderen copolymerisierbaren Monomeren ableiten.

Bevorzugt werden Copolymere, welche neben den Strukturelementen der Formel II mindestens eines der Strukturelemente der Formeln III oder IV enthalten

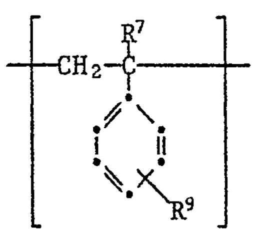 (III) 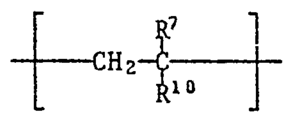 (IV) ,

worin $R^7$ die oben angegebene Bedeutung hat, $R^8$ für Wasserstoff, $C_1$-$C_4$-Alkyl oder $C_1$-$C_4$-Alkoxy und $R^{10}$ für Wasserstoff, $C_1$-$C_4$-Alkyl, $C_1$-$C_4$-Alkoxy, $C_1$-$C_4$-Alkoxycarbonyl oder $C_1$-$C_4$-Alkylcarbonyloxy stehen.

Die $C_1$-$C_4$-Alkylgruppen der Reste $R^9$ und $R^{10}$ können verzweigt oder vorzugsweise geradkettig sein und sind z.B. Butyl, Propyl, Ethyl und insbesondere Methyl.

Typische Vertreter von Monomeren, von welchen sich die Strukturelemente der Formeln III und IV ableiten, sind Styrol, α-Methylstyrol, Methylacrylat oder -methacrylat und Vinylacetat.

Besonders bevorzugte Monomere, von welchen sich die Strukturelemente der Formel II ableiten, sind 4-(2′-Trimethylsilyl-2′-propoxycarbonyloxy)-stryol, 4-(2′-Trimethlsilyl-2′-propoxycarbonyloxy)-α-methylstyrol und 4-(1′,1′-Bistrimethylsilylethoxycarbonyloxy)-α-methylstyrol.

Die erfindungsgemässen organometallhaltigen Polymere mit Gruppierungen der Formel I können entweder durch Polymerisation entsprechender, diese Gruppierungen bereits enthaltender Monomere der Formel II*

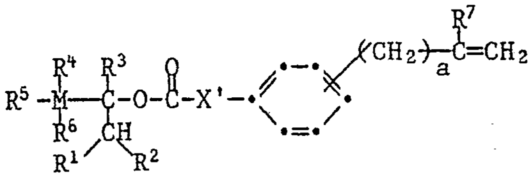

(II*),

oder durch Modifizierung eines Polymers durch Umsetzung mit einer organometallhaltigen Verbindung der Formel I*

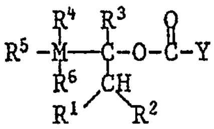

(I*)

erhalten werden, wobei in den Formeln I* und II* $R^1$-$R^7$, M und a die oben angegebene Bedeutung haben, X′ für O, S oder NH steht und Y eine für eine nukleophile Substitution geeignete Abgangsgruppe ist.

Für die Umsetzung mit Verbindungen der Formel I* besonders geeignete Polymere sind jene, welche nukleophile funktionelle Gruppen, wie z.B. Hydroxyl-, Mercapto-, Amino-, ode Imidogruppen enthalten. Dabei entstehen erfindungsgemässe Polymere, worin die Gruppierungen der Formel I direkt oder z.B. über eine Gruppe der Formel V

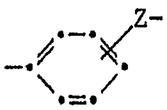

(V),

worin Z O, S oder NR′ mit R′ gleich Wasserstoff oder einfache Bindung bedeutet, an einen Polyalkohol, ein Polyphenol, ein Polythiol, ein Polyamin, oder ein Polyimid gebunden sind. Bei diesen Polymeren sind die Reste X oder Z der organometallhaltigen Gruppierung O, S oder NR′ Atome bzw. Gruppen, welche am ursprünglichen, nicht modifizierten Polymer vorhanden waren und durch nukleophile Substitution der Abgangsgruppe Y der Verbindungen der Formel I* mit der organometallhaltigen Gruppierung verbunden wurden. Für die Umsetzung geeignete Polymere sind z.B. Polyvinylalkohol, Phenol- oder Kresolnovolake, Poly-4-hydroxystyrol, Polymaleinimid usw. Die Umsetzung erfolgt vorzugsweise in einem aprotischen Lösungsmittel, wie Toluol, Tetrahydrofuran oder Methylenchorid, falls zweckmässig in Gegenwart einer Base, z.B. eines tertiären Amins, wie Pyridin oder Dimethylanilin.

Die Polymerisation bzw. Copolymerisation der organometallhaltigen Monomere der Formel II* und gegenbenenfalls zusätzlich der Monomere, von denen sich die Strukturelemente der Formeln III und IV ableiten, erfolgt auf an sich bekannte Weise radikalisch oder kationisch, z.B. in Gegenwart von katalytischen Mengen von 2,2′-Azobisisobutyronitril bzw. von Bortri fluorid-ethyletherat. Die Monomere, von denen sich die Strukturelemente III und IV ableiten, sind bekannt und können auf bekannte Weise hergestellt werden.

Die organometallhaltigen Monomere der Formel II* können hergestellt werden entweder

a) direkt durch Umsetzung eines organometallhaltigen Alkohols der Formel VI

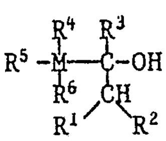

(VI)

mit einem Chlorameisensäurederivat der Formel VIIa

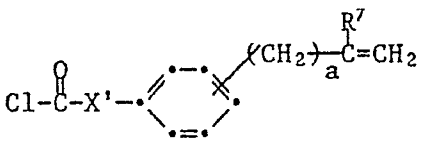

(VIIa)

oder durch Umsetzung eines organometallhaltigen Chlorformiats der Formel IX

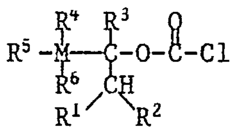

(IX)

mit einer Verbindung der Formel Xa

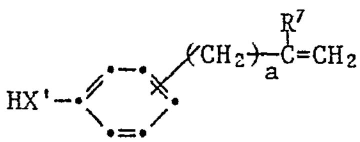

(Xa)

oder

b) über die ensprechenden Carbonylverbindungen durch Umsetzung des organometallhaltigen Alkohols der Formel VI mit einem Chlorameisensäurederivat der Formel VIIb

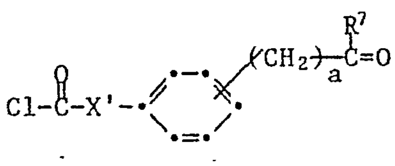

(VIIb)

zur Carbonylverbindung der Formel VIII

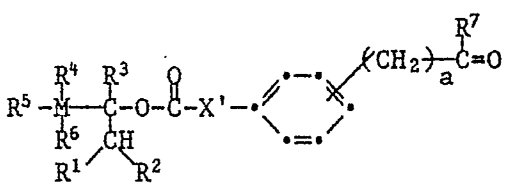

(VIII) oder

durch Umsetzung des organometallhaltigen Chlorformiats der Formel IX mit einer Verbindung der Formel Xb

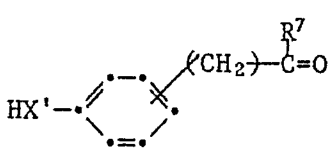

(Xb)

zur Verbindung der Formel VIII und anschliessende Wittig-Reaktion der Carbonylverbindung der Formel VIII mit einem Phosphorylid, wobei die Symbole $R^1$ bis $R^7$, M, X′ und a in den Formeln VI bis X die oben für die Formeln I und II angegebene Bedeutung haben.

Organometallhaltige Alkohole der Formel VI sind bekannt oder können auf bekannte Weise hergestellt werden. So wird in J. Organomet. Chem. 49 (1973) C9-C12 die Herstellung eines siliciumhaltigen Alkohols durch Umsetzung von Trimethylchlorsilan mit Aceton beschrieben. Organometallhaltige Alkohole der Formel VII können auch, wie in J.Org.Chem. 45 (1980) 3571-3578, in Zh. Obshch. Khim. 36 (1966) 1709 in Tetrahedron Lett. 1976, 1591-1594 oder in J. Organomet. Chem. 1981, 33-47 beschrieben, oder auf analoge Weise,

hergestellt werden.

Chlorameisensäurederivate der Formel VII sind ebenfalls bekannt und können z.B. durch Umsetzung von Phosgen mit einem substituierten Phenol, Thiophenol oder Anilin der Formel X, vorzugsweise in Anwesenheit einer Base, z.B. eines tertiären Amins, wie Pyridin oder Dimethylanilin, hergestellt werden. Auf analoge Art können auch organometallhaltige Chlorformiate der Formel IX synthetisiert werden, indem ein Alkohol der Formel VI mit Phosgen umgesetzt wird. Eine Herstellungsmethode von Chlorameisensäurederivaten der Formel VIIa ist z.B. in Angew. Makromol. Chem. 60/61 (1977) 125-137 oder in der DE-OS 25 08 512 beschrieben. Chlorameisensäurederivate der Formel IIIa können auch durch Umsetzung der entsprechenden Verbindungen der Formel VIa mit Phosgen, wie z.B. in der DE-PS 1 193 031 beschrieben, hergestellt werden. Eine Vielzahl geeigneter Synthesen von Chlorameisensäurederivaten, wie z.B. Chlorformiaten, sowie deren Reaktionsprodukte mit Alkoholen, Thiolen und Aminen ist z.B. in Chem. Rev. 64 (1964) 645-687 beschrieben.

Verbindungen der Formel X sind bekannt und sind im allgemeinen auch im Handel erhältlich.

Die organometallhaltigen Carbonylverbindungen der Formel VIII wurden für die Herstellung der erfindungsgemässen Polymere mit Struktureinheiten der Formel II entwickelt. Sie können z.B. mittels einer Wittig-Reaktion in bekannter Weise durch Umsetzung mit einem Phosphorylid in die Styrolderivate der Formel II* übergeführt werden. Geeignete Phosphorylide können z.B. durch Umsetzung eines Methyltriarylphosphoniumsalzes, wie Methyltriphenylphosphoniumbromid, mit starker Base, wie Natriumhydrid oder Kalium-tert.-butylat hergestellt werden. Wittig-Reaktionen sind in vielen Uebersichten beschrieben, wie z.B. in House "Modern Synthetic Reactions", 2. Aufl., Seiten 682-709, W.A. Benjamin Inc., Menlo Park CA, U.S.A., 1972.

Für eine nukleophile Substitution geeignete Abgangsgruppen Y der Verbindungen der Formel I* sind bekannt. Die wichtigste Voraussetzung bei der Wahl der Abgangsgruppe ist, dass diese weniger nukleophil ist als die funktionellen Gruppen des Polymers, mit denen sie umgesetzt werden soll.

Besonders geeignete Abgangsgruppen Y der Verbindungen der Formel I* sind mit Elektronenakzeptorgruppen substituierte Phenoxy-Reste oder fünf- oder sechsgliedrige Heterocyclen mit mindestens einem, vorzugsweise zwei Heteroatomen, wie z.B. O-, S- und insbesondere N-Atomen im Ring, welche über eines dieser Heteroatome an die Carbonylgruppe im Molekül gebunden sind. Beispiele geeigneter Reste Y sind z.B. 1-Imidazolyl oder eine Gruppe der Formel XI

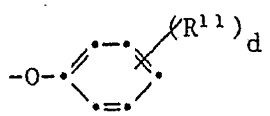 (XI),

worin $R^{11}$ Halogen, insbesondere Fluor, Chlor oder Brom, $NO_2$, CN oder $CF_3$ und d eine ganze Zahl von 1 bis 5, vorzugsweise von 1 bis 3, bedeuten. Ein besonders geeigneter Rest der Formel XI ist 4-Nitrophenoxy.

Verbindungen der Formel I* können in an sich bekannter Weise, z.B. durch Umsetzung der organometallhaltigen Chlorformiate der Formel IX mit einer Verbindung der Formel XII

YH (XII)

hergestellt werden.

Ein anderer geeigneter Syntheseweg ist die Umsetzung der organometallhaltigen Alkohole der Formel VI mit einem Chlorameisensäurederivat der Formel XIII

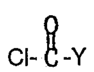 (XIII),

oder mit einer Carbonylverbindung der Formel XIV

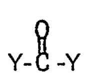 (XIV),

wobei die Verbindungen der Formeln VI und IX sowie Y in den Formeln XII, XIII und XIV die oben angegebene Bedeutung haben.

Die Verbindungen der Formeln XIII oder XIV können z.B. durch Umsetzung von Phosgen mit einer Verbindung der Formel XII hergestellt werden.

Die Verbindungen der Formel XII sind bekannt und im allgemeinen im Handel erhältlich.

Der Syntheseweg über Verbindungen der Formel XIV bei der Herstellung von Verbindungen der Formel I* ist beonders geeignet, wenn Y einen der oben erwähnten heterocyclischen Reste bedeutet. Eine geeignete Verbindung der Formel XIV ist z.B. 1,1′-Carbonyldiimidazol.

Die erfindungsgemässen Polymere eignen sich vortrefflich als strahlungssensitives, trocken entwickelbares Aufzeichnungsmaterial. Wie bereits erwähnt, lassen sich die Polymere mit Gruppierungen der Formel I zur

Herstellung von negativ oder vorzugsweise positiv arbeitenden Photoresistsystemen verwenden.

Die Erfindung betrifft daher auch strahlungssensitive, trocken entwickelbare Zusammensetzungen enthaltend ein erfindungsgemässes organometallhaltiges Polymer mit Seitenketten der Formel I und eine unter Einwirkung von Strahlung eine Säure freisetzende Verbindung.

Als strahlungsempfindliche Komponenten, die bei Lichteinwirkung Säure bilden bzw. abspalten, sind eine grosse Anzahl von Verbindungen bekannt. Dazu zählen beispielsweise Diazoniumsalze, wie sie in der Diazotypie verwendet werden, o-Chinondiazide, wie sie in bekannten positiv arbeitenden Kopiermassen verwendet werden, oder auch Halogenverbindungen, die bei Bestrahlung Halogenwasserstoffsäure bilden. Verbindungen dieses Typs sind beispielsweise in den US 3,515,552, 3,356,489 oder 3,779,778, sowie in den DE-OS 27 18 259, 22 43 621 oder 26 10 842 beschrieben.

Als strahlungsempfindliche Komponenten der erfindungsgemässen Zusammensetzungen eignen sich aber auch kationische Photoinitiatoren aus der Gruppe der Iodonium- oder Sulfoniumsalze. Solche Verbindungen sind beispielsweise in "UV-Curing, Science and Technology" (Editor: S.P. Pappas, Technology Marketing Corp., 642 Westover Road, Stamford, Conneticut, USA) beschrieben.

Insbesondere sind auch Diaryliodosyl-Salze einsetzbar. Solche Verbindungen sind beispielsweise in der EP-A 106 797 beschrieben.

Ferner können Sulfoxoniumsalze als strahlungsempfindliche Verbindungen verwendet werden. Solche Salze sind beispielsweise in der EP-A 35 969, 44 274 bzw. 54 509 beschrieben. Insbesondere zu erwähnen sind aliphatische Sulfoxoniumsalze, die im tiefen UV-Bereich absorbieren.

Insbesondere lassen sich auch Verbindungen einsetzen, die bei Bestrahlung mit aktinischem Licht Sulfonsäuren freisetzen. Solche Verbindungen sind an sich bekannt und beispielsweise in der GB-A 2 120 263, den EP-A 84 515, 37 512 oder 58 638 bzw. in den US 4,258,121 oder 4,371,605 beschrieben.

Werden als strahlungsempfindliche, säureabspaltende Komponenten Salze eingesetzt, so sind diese vorzugsweise in organischen Lösungsmitteln löslich. Besonders bevorzugt handelt es sich bei diesen Salzen um Abscheidungsprodukte mit komplexen Säuren, beispielsweise von Borfluorwasserstoffsäure, Hexafluorphosphorsäure oder Hexafluorarsensäure, oder von Perfluoralkansulfonsäuren, wie Trifluormethansulfonsäure. Geeignete Salze sind z.B. Diphenyliodonium-, Triphenylsulfonium- oder 4-Phenylthiophenyldiphenylsulfonium-Hexafluorarsenat oder Diphenyliodonium-Trifluormethansulfonat.

Die Menge der strahlungsempfindlichen Komponente der erfindungsgemässen Zusammensetzungen kann je nach Natur und Zusammensetzung des strahlungsempfindlichen Gemisches in weiten Grenzen variiert werden. Günstige Ergebnisse werden erzielt, wenn etwa 1 bis 20 Gew.-%, vorzugsweise 3 bis 15 Gew.%, insbesondere 5 bis 10 Gew.%, der säureabspaltenden Komponente, bezogen auf das Polymer eingesetzt werden. Da die strahlungsempfindliche Komponente (Initiator) nach der Trockenentwicklung im System zurückbleibt, wird vorzugsweise möglichst wenig dieser Substanzen eingesetzt, um nachteilige Beeinflussungen in weiteren Prozesschritten zu verhindern. Bevorzugt werden strahlungsempfindliche Initiatoren eingesetzt, welche bei der Trockenentwicklung vollständig entfernt werden.

Die erfindungsgemässen Zusammensetzungen können weitere übliche Zusatzstoffe enthalten, wie z.B. Stabilisatoren, Sensibilisatoren, z.B. polycyclische Aromaten, wie Pyren, Anthracen oder Perylen, oder als Sensibilisatoren geeignete Farbstoffe, wie z.B. Acridine, gebräuchliche Polymere, wie Polystyrol oder Polymethylmethacrylat, Pigmente, Farbstoffe, Füllstoffe, Haftvermittler, Verlaufsmittel, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie von Metallen, wie Al, Cu, Ni, Fe, Zn, Mg oder Co, und von Halbleitermaterialien wie Si, $Si_3N_4$, $SiO_2$, GaAs, Ge, etc., bei denen durch bildmässiges Belichten eine Abbildung aufgebracht werden soll. Ein weiterer Gegenstand vorliegender Erfindung sind die Verwendung der erfindungsgemässen Zusammensetzungen zur Herstellung von strukturierten Positivbildern sowie die mit den Zusammensetzungen beschichteten Substrate.

Die Herstellung der beschichteten Substrate kann z.B. erfolgen, indem man eine Lösung oder Suspension der Zusammensetzung herstellt. Als Lösungsmittel eignen sich alle nicht allzu polaren und nicht zu niedrig siedenden Lösungsmittel, z.B. Ether, Ketone oder Aromaten, wie Tetrahydrofuran, Dioxan, Cyclohexanon, Benzol oder Toluol. Bevorzugt sind 1-20%ige, insbesondere 5-15%ige Polymerlösungen. Die Lösung wird mittels bekannten Beschichtungsverfahren auf ein Substrat gleichförmig aufgebracht, z.B. durch Schleudern (spin coating), Tauchen, Rakelbeschichtung, Vorhanggiessverfahren, Aufpinseln, Sprühen und Reverse Rollbeschichtung. Es ist auch möglich, die lichtempfindliche Schicht auf einen temporären, flexiblen Träger zu bringen, und dann durch Schichtübertragung via Lamination das endgültige Substrat, z.B. einen Silicium Wafer, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in sehr dünnen Schichten eingesetzt werden können, und sich durch eine hervorragende Auflösung auszeichnen. Sie eignen sich bei entsprechend gewählter Strahlungsquelle und strahlungsempfindlicher Komponente für ein breites Spektrum von Anwendungsgebieten, wo die Erzeugung von strukturierten Bildern erwünscht ist. Besonders vorteilhaft ist ihr Einsatz jedoch in der Submikronlithographie sowie der Mehrschichtenlithographie, wo heute die Anforderungen der Mikroelektronik an ein Resistsystem besonders hoch sind. Daher sind

bevorzugte Filmschichtdicken 0,3-2,0 µm.

Nach dem Beschichten wird das Lösungsmittel üblicherweise durch Trocknen entfernt und es resultiert eine amorphe Schicht des Resists auf dem Träger.

Zwischen Träger und Resist kann, falls erwünscht, eine weitere Schicht aufgetragen werden. Dieses sogenannte Planarisierharz ermöglicht das Auftragen besonders dünner homogener Resistschichten auf einem Träger mit Topographie. Grundsätzlich eignen sich alle organischen Polymere und Oligomere, welche als Polymerlösung auf einen Träger aufgebracht werden können. Beispiele solcher sind Polyimide, Polyamidsäuren, Polymethylmethacrylat, Novolake oder auch andere Resistsysteme.

Die strahlungssensitive Schicht wird in üblicher Weise bildmässig einer geeigneten Strahlung ausgesetzt. Die belichteten Stellen dieser Schicht zerfallen bei Anwendung von Wärme in $CO_2$, die leichtflüchtige Verbindung

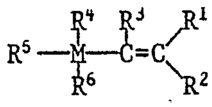

und in den Rest

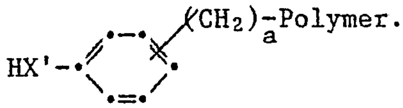

Nach dem Verdampfen der leichtflüchtigen Verbindung sind die belichteten Stellen somit frei von metallhaltigen Gruppierungen. Mit Hilfe eines Sauerstoffplasmas können diese metallfreien Stellen entwickelt werden, während die nichtbelichteten Stellen, welche noch metallhaltige Gruppierungen enthalten, dem Sauerstoffplasma wiederstehen. Es ist ein Vorteil des erfindungsgemässen Systems, dass bei dieser sauberen und rückstandsfreien Trockenentwicklung kein Lösungsmittel verwendet werden muss und dass Positivbilder sehr hoher Auflösung erhalten werden.

Für die nach dem Belichtungsschritt durchgeführte Erwärmung zur Entfernung der leichtflüchtigen Zersetzungsprodukte werden Temperaturen zwischen 70°C und 120°C während 1-60, insbesondere 5-30 Minuten bevorzugt.

Belichtungen mit aktinischer Strahlung werden durch eine Quartzmaske, die ein vorbestimmtes Muster enthält, oder durch einen Laserstrahl, der beispielsweise computergesteuert über die Oberfläche des beschichteten Substrates bewegt wird, durchgeführt.

Bevorzugt werden zur Belichtung UV-Strahlen (200-450 nm), Elektronenstrahlen, Röntgenstrahlen oder Ionenstrahlen verwendet.

Was das erfindungsgemässe System gegenüber dem Stand der Technik ausserdem auszeichnet, ist dessen unerwartet hohe Empfindlichkeit bei gleicher Schichtdicke. So kommt man mit beispielsweise 1-10 $mJ/cm^2$ aus, um zum gewünschten Resultat zu kommen.

Die nachfolgenden Beispiele erläutern die Erfindung näher.

Beispiel 1:

2-Trimethylsilyl-2-propanol

In einem 10 l Planschliffgefäss mit mechanischem Rührer werden unter Stickstoff 83 g (12 Mol) Lithiumpulver vorgelegt. Dazu gibt man 6 l trockenes THF und kühlt auf 0°C ab. 1500 g Trimethylchlorsilan (13,8 Mol) und 313 g Aceton (5,4 Mol) werden gemischt und via Tropftrichter zur Lithiumsuspension getropft. Dabei soll die Reaktionstemperatur 0°C betragen. Nach der Zugabe wird die Kühlung entfernt und 1 - 2 Stunden bei 50°C gerührt. Die Lösung wird vom Salz und vom überschüssigen Lithium abgetrennt. Der Rückstand wird mit n-Pentan gewaschen und das Filtrat eingeengt. Dabei wird bei Normaldruck zuerst das Lösungsmittel über eine verspiegelte Füllkörperkolonne abgetrennt. Danach wird bei 20 mbar der Trimethylsilylether von 2-Trimethylsilyl-2-propanol gewonnen. Man erhält 300g (28 %) einer farblosen Flüssigkeit vom Siedepunkt 47-48°C.

$^1$H-HMR ($CCl_4$):

0 ppm (s, 9H) $(H_3C)_3Si$-C

0,1 ppm (s, 9H) $(H_3C)_3Si$-O

1,3 ppm (s, 6H) $(H_3C)_2C$

| Elementaranalyse: | berechnet | gefunden |
|---|---|---|
| % C | 52,8 | 51,6 |
| % H | 11,8 | 11,7 |

232 g des Trimethylsilylethers werden in 900 ml Diethylether gelöst und mit 700 ml 15 %iger HCl versetzt. Unter starkem Rühren wird das 2-Phasengemisch etwa eine Stunde lang unter Rückfluss erhitzt. Die organische Phase wird abgetrennt, einmal mit Wasser und dann gründlich mit Natriumbicarbonatlösung gewaschen, getrocknet und der Ether wird bei Normaldruck abgedampft. Der Rückstand wird bei 100 mbar über eine Füllkörperkolonne destilliert. Man erhält 63 g (65%) einer klaren Flüssigkeit, die bei 65°C destilliert und gemäss GC eine Reinheit von mehr als 97 % aufweist.

$^1$H-HMR ($CCl_4$):
0 ppm (s, 9H) $(H_3C)_3Si$
1,1 ppm (s, 6H) $(H_3C)_2C$
1,7 ppm (s, 1H) HO-

| Elementaranalyse: | berechnet | gefunden |
|---|---|---|
| % C | 54,48 | 54,19 |
| % H | 12,19 | 11,98 |

Beispiel 2:

4-(2′-Trimethylsilyl-2′-propoxycarbonyloxy)styrol

Unter Stickstoff werden in einem 5 l Planschliffgefäss mit mechanischem Rührer und Thermometer 244 g (2 Mol) 4-Hydroxybenzaldehyd und 2 l 2M Phosgenlösung in Toluol (4 Mol Phosgen) vorgelegt. Bei -5°C tropft man 242 g (2 Mol) Dimethylanilin dazu. Nach dem Zutropfen wird noch 2 Stunden bei 0°C gerührt. Man lässt auf Raumtemperatur erwärmen, treibt mit Stickstoff das überschüssige Phosgen aus und giesst auf Eiswasser. Die organische Phase wird gründlich mit verdünnter Salzsäure gewaschen und mit Natriumsulfat getrocknet. Am Rotationsverdampfer wird das Lösungsmittel abdestilliert. Der Rückstand wird am Hochvakuum destilliert. Man erhält 250 g (68 %) 4-(Chlorcarbonyloxy)benzaldehyd, eine glasklare Flüssigkeit, die bei 84°C/0,2 mbar siedet. Beim Abkühlen wird die Flüssigkeit fest; der Schmelzpunkt liegt etwas oberhalb der Raumtemperatur.

| Elementaranalyse: | berechnet | gefunden |
|---|---|---|
| % C | 52,06 | 51,07 |
| % H | 2,73 | 2,74 |
| % Cl | 19,21 | 21,26 |

43 g (233 mmol) dieses Chlorformiates werden in 30 ml Methylenchlorid gelöst und unter Stickstoff zu einer Lösung von 30,8 g (233 mmol) 2-Trimethylsilyl-2-propanol und 18,4 g Pyridin (233 mmol) in 120 ml Methylenchlorid getropft. Dabei wird die Lösungstemperatur auf $\leq$ 5°C gehalten. Nach dem Zutropfen lässt man auf Raumtemperatur erwärmen. Nach 12 Stunden unter Stickstoff wird vom Salz abgetrennt und die organische Phase mit verdünnter Salzsäure, Wasser und Natriumbicarbonatlösung gewaschen. Nach dem Trocknen wird vom Lösungsmittel befreit. Der Rückstand wird über Silicagel mit Chloroform als Laufmittel chromatographiert. Man erhält 30,6 g (46 %) 4-(2′-Trimethylsilyl-2′-propyloxycarbonyloxy)benzaldehyd als farblose Flüssigkeit.

$^1$H-HMR (Aceton-$d_6$):
0,1 ppm (s, 9H) $(H_3C)_3Si$

1,5 ppm (s, 6H) $(H_3C)_2C$
7,3-7,9 ppm (m, 4H) H-Ar.
10 ppm (s, 1H) CHO

| Elementaranalyse: | berechnet | gefunden |
|---|---|---|
| % C | 59,97 | 59,62 |
| % H | 7,19 | 7,18 |
| % Si | 10,01 | 9,95 |

Das Benzaldehyderivat wird mittels Wittigreaktion ins entsprechende Styrolderivat überführt: In einem l l 3-Hals-Rundkolben mit Tropftrichter und Thermometer werden 38,6 g (108 mmol) Methyltriphenylphosphoniumbromid in 400 ml trockenem THF vorgelegt. Dazu gibt man 12,2 g (108 mmol) Kalium-tert.-butylat und lässt unter Stickstoff 1 Stunde bei Raumtemperatur rühren. 20 g (72 mmol) Benzaldehydderivat, gelöst in 180 ml THF werden nun bei Raumtemperatur zugetropft. Nach 15 Stunden zeigt das DC (Toluol/Hexan = 1:1) nur das Produkt. Man giesst auf Eis und zieht zweimal mit n-Hexan aus. Die organische Phase wird zweimal mit Wasser gewaschen, getrocknet und eingedampft. Der Rückstand wird über eine Silicagelsäule mit Toluol/Hexan = 1:1 chromatographiert. Man erhält 13 g (65 %) einer farblosen Flüssigkeit, die sich am Hochvakuum destillieren lässt (Siedepunkt 110°C/0,05 mbar).
$^1$H-HMR (Aceton-$d_6$):
0.05 ppm (s, 9H) $(H_3C)_3Si$
1,45 ppm (s, 6H) $(H_3C)_2C$
5,1-5,8 ppm (m, 2H) $H_2C=$
6,5-6,8 ppm (m, 1H) $=CH-$
7,0-7.5 ppm (m, 4H) H-Ar.

| Elementaranalyse: | berechnet | gefunden |
|---|---|---|
| % C | 64,71 | 63,95 |
| % H | 7,97 | 7,91 |
| % Si | 10,09 | 10,24 |

Beispiel 3:

4-(2′-Trimethylsilyl-2′-propoxycarbonyloxy)-α-methylstyrol

Dieses Monomer wird ausgehend von 4-Hydroxyacetophenon genau wie das in Beispiel 2 beschriebene Styrolderivat hergestellt. Die Ausbeuten und die physikalischen Daten der hergestellten Verbindungen sind wie folgt:

4-(Chlorcarbonyloxy)acetophenon
Ausbeute 82 %, Schmelzpunkt 33°C.
$^1$H-HMR ($CDCl_3$):
2,6 ppm (s, 3H)

$H_3C-$
7,25-8,10 ppm (m, 4H) H-Ar.

| Elementaranalyse: | berechnet | gefunden |
|---|---|---|
| % C | 54,43 | 54,41 |
| % H | 3,55 | 3,59 |
| % Cl | 17,85 | 17,78 |

<u>4-(2′-Trimethylsilyl-2′-propoxycarbonyloxy)acetophenon</u>
Ausbeute 68 %, Schmelzpunkt 41°C.
$^1$H-HMR (Aceton-$d_6$):
0,1 ppm (s, 9H)$(H_3C)_3Si$
1,5 ppm (s, 6H) $(H_3C)_2C$
2,6 ppm (s, 3H)

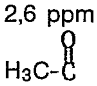

7,25-8,1 ppm (m, 4H) H-Ar.

| Elementaranalyse: | berechnet | gefunden |
|---|---|---|
| % C | 61,19 | 60,90 |
| % H | 7,53 | 7,48 |

<u>4-(2′-Trimethylsilyl-2′-propoxycarbonyloxy)-α-methylstyrol</u>
Ausbeute 53 %, Siedpunkt 118°C/0,04 mbar.
$^1$H-HMR (Aceton-$d_6$):
0,1 ppm (s, 9H)$(H_3C)_3Si$
1,5 ppm (s, 6H) $(H_3C)_2C$
2,1 ppm (m, 3H)

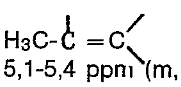

5,1-5,4 ppm (m, 2H)

$H_2C=$
7,1-7,6 ppm (m, 4H) H-Ar.

| Elementaranalyse: | berechnet | gefunden |
|---|---|---|
| % C | 65,71 | 65,77 |
| % H | 8,27 | 8,30 |

<u>Beispiel 4:</u>

<u>Poly[4-(2′-Trimethylsilyl-2′-propoxycarbonyloxy)styrol]</u>

10 g (36 mmol) 4-(2′-Trimethylsilyl-2′-propoxycarbonyloxy)styrol (hergestellt gemäss Beispiel 2) werden in 20 ml Toluol gelöst und mit 1 Mol% 2,2′-Azobisisobutyronitril versetzt. Die Lösung wird vom Sauerstoff befreit und unter Stickstoff bei 70°C polymerisiert. Nach ein paar Stunden wird die viskose Lösung mit 50 ml Methylenchlorid verdünnt und auf 500 ml Methanol gegossen. Das ausgefallene Polymer wird nochmals in Methylenchlorid gelöst und erneut in Methanol ausgefällt. Das Polymer wird bei 50°C am Hochvakuum getrocknet. Ausbeute 6 g (60 %).

$^1$H-HMR ($CDCl_3$):
0,1 ppm (s, 9H) $(H_3C)_3Si$
0,75 - 2,25 (m/s, 9H) $-CH_2-CH-$
und $(H_3C)_2C$
6,2 - 7,1 ppm (m, 4H) H-Ar.

| Elementaranalyse: | berechnet | gefunden |
|---|---|---|
| % C | 64,71 | 64,75 |
| % H | 7,96 | 7,92 |

Mittels Gelpermeationschromatographie (GPC) in Tetrahydrofuran mit Polystyrol als Standard wird ein Molekulargewicht von $\overline{M}_n = 42000$ und $\overline{M}_w = 87000$ bestimmt.

Thermogravimetrische Analyse: Bei einer Aufheizgeschwindigkeit von 4°C/Min. in Luft hat man bei 160°C ca. 10 % Gewichtsverlust. Bei 175°C ist die Verbindung vollständig decarboxyliert. Der Gewichtsverlust beträgt 55 %, was genau der Abspaltung von $CO_2$ und von Isopropenyltrimethylsilan entspricht.

Beispiel 5:

Poly[4-(2′-Trimethylsilyl-2′propoxycarbonyloxy)-α-methylstyrol]

In einem 100 ml Rundkolben mit Glasaufsatz werden 20 g (68 mmol) des Monomers in 60 ml Methylenchlorid gelöst. Man entfernt den Sauerstoff aus der Lösung und gibt unter Stickstoff bei -78°C 1,1 ml einer 1M Lösung von $BF_3 \bullet Et_2O$ in Methylenchlorid dazu. Nun lässt man bei -20 bis -40°C polymerisieren. Nach 18 Stunden wird die viskose Lösung in 1 Liter Methanol gegossen. Das ausgefallene Polymer wird abgetrennt, getrocknet und nochmals in Methylenchlorid/Methanol umgefällt. Danach wird bei 50°C am Hochvakuum getrocknet. Man erhält 13 g (65 %) des Polymers.
$^1$H-NMR ($CDCl_3$):
0,1 ppm (s, 9H) $(H_3C)_3Si$
1,0-2,1 ppm (m/s, 11H) $H_3C-C$, $-CH_2-$, $H_3C-C-CH_3$
6,4-1,2 ppm (m, 4H) H-Ar.

| Elementaranalyse: | berechnet | gefunden |
|---|---|---|
| % C | 65,71 | 65,73 |
| % H | 8,27 | 8,20 |
| % Si | 9,60 | 9,68 |

GPC-Messungen in THF zeigen ein $\overline{M}_n$ von 33000 und ein $\overline{M}_w$ von 84000.

TGA-Analyse: Bei einer Aufheizgeschwindigkeit von 4°C/Minute in Luft hat man bei 155°C ca. 10 % Gewichtsverlust und bei 171°C ca. 53 % Gewichtsverlust. Der Gewichtsverlust von 53 % entspricht der vollständigen Abspaltung von $CO_2$ und Isopropenyltrimethylsilan.

Beispiel 6:

4-(2′-Trimethylsilyl-2′-propoxycarbonyloxy)nitrobenzol

Unter Stickstoff werden in einem 100 ml Glaskolben, der mit Thermometer, Tropftrichter und Magnetrührer ausgerüstet ist, 10 g (76 mmol) 2-Trimethylsilyl-2-propanol, 6 g (76 mmol) Pyridin und 30 ml Methylenchlorid vorgelegt und die Lösung wird auf 0°C abgekühlt. 15,2 g (76 mmol) Chlorameisensäure-4-nitrophenylester werden in 20 ml Methylenchlorid gelöst und so zur vorgelegten Lösung getropft, dass die Temperatur zwischen 0°C und 5°C bleibt. Nach dem Zutropfen lässt man auf Raumtemperatur erwärmen und rührt noch etwa 1 Stunde nach. Man giesst auf Eiswasser, wäscht die organische Phase mit 1N HCl und anschliessend mit $NaHCO_3$. Die getrocknete organische Phase wird eingeengt und der Rückstand mit n-Hexan

umkristallisiert. Man erhält 10 g (44 %) kristalline Substanz vom Schmelzpunkt 61°C.
$^1$H-NMR (Aceton-$d_6$):
0,1 ppm (s, 9H) $(H_3C)_3Si$
1,55 ppm (s, 6H) $(H_3C)_2C$
7,4-8,1 ppm (m, 4H) H-Ar.

| Elementaranalyse: | berechnet | gefunden |
|---|---|---|
| % C | 52,51 | 52,31 |
| % H | 6,44 | 6,41 |
| % N | 4,71 | 4,60 |

Beispiel 7:

1-(2'-Trimethylsilyl-2'-propoxycarbonyl)imidazol

Unter Stickstoff werden in einem Sulfierkolben, der mit Kühler, Thermometer und Magnetrührer versehen ist, 10 g (76 mmol) 2-Trimethylsilyl-2-propanol, 14,7 g (91 mmol) 1,1'-Carbonyldimidazol und 50 ml Methylenchlorid vorgelegt. Dann wird die Mischung während 21 Stunden unter Rückfluss gerührt. Man giesst auf Eiswasser, trennt die Phasen und wäscht die organische Phase noch zweimal mit Wasser. Die organische Phase wird getrocknet, am Rotationsverdampfer eingeengt und der Rückstand im Hochvakuum destilliert. Man erhält 11,3 g (66 %) einer farblosen Flüssigkeit mit einem Siedepunkt von 90°C/0,1 mbar.
$^1$H-NMR (Aceton-$d_6$):
0,2 ppm (s, 9H) $(H_3C)_3Si$
1,6 ppm (s, 6H) $(H_3C)_2C$
7,74 und 8,1 ppm (s, 3H) H-Imidazol

| Elementaranalyse: | berechnet | gefunden |
|---|---|---|
| % C | 53,06 | 52,31 |
| % H | 8,02 | 8,02 |
| % N | 12,38 | 12,40 |

Beispiel 8:

4-(1',1'-Bistrimethylsilylethoxycarbonyloxy)-α-methylstryrol

Die Kondensationsreaktion zwischen 4-(Chlorcarbonyloxy)acetophenon und 1,1-Bistrimethylsilylethanol (hergestellt nach Tetrahedron Lett., 1976, 1591-1594) in Methylenchlorid verläuft analog zu der im Beispiel 2 beschriebenen Kondensation. Nach der säulenchromatographischen Reinigung erhält man einen Festkörper, der in Hexan umkristallisiert werden kann.

4-(1',1'-Bistrimethylsilylethoxycarbonyloxy)acetophenon
Ausbeute 60 %, Schmelpunkt 79,5°C.
$^1$H-NMR ($CDCl_3$):
$(CH_3)_3Si$ (18H, s) : 0,12 ppm
$CH_3$-C (3H, s) : 1,6 ppm
$CH_3$-C=O (3H, s) : 2,6 ppm
Aromat (4H, m) : 7,2-8,05 ppm

| Elementaranalyse: | berechnet | gefunden |
|---|---|---|
| % C | 57,91 | 58,01 |
| % H | 8,01 | 8,13 |
| % Si | 15,93 | 15,92 |

4-(1′,1′-Bistrimethylsilylethoxycarbonyloxy)-α-methylstyrol

Die Wittigreaktion wird analog dem Beispiel 2 durchgeführt. Nach der säulenchromatographischen Reinigung erhält man eine farblose Flüssigkeit in 41 % Ausbeute.

$^1$H-NMR ($CDCl_3$):
$(CH_3)_3Si$ (18H, s) : 0,15 ppm
$CH_3$-C (3H, s) : 1,6 ppm
$CH_3$-C= (3H, m) : 2,15 ppm
$CH_2$=C (2H, m) : 5,04-5,33 ppm
Aromat (4H, m) : 7,00-7,53 ppm

| Elementaranalyse: | berechnet | gefunden |
|---|---|---|
| % C | 61,66 | 61,57 |
| % H | 8,63 | 8,77 |
| % Si | 16,02 | 16,08 |

Beispiel 9:

Poly[4-(1′,1′-Bistrimethylsilylethoxycarbonyloxy)-α-methylstyrol]

In einem 250 ml Rundkolben mit Magnetrührer werden 20 g (57 mmol) 4-(1′,1′-Bistrimethylsilylethoxycarbonyloxy-α-methylstyrol (hergestellt gemäss Beispiel 8) in 60 ml wasserfreiem Methylenchlorid gelöst und an einer Vakuum/Stickstofflinie mit Hilfe der Gefrier-/Tautechnik sauerstofffrei gemacht. Die Lösung wird aud minus 60° C gekühlt und mit 1,2 mmol frisch destilliertem $BF_3 \bullet Et_2O$ versetzt. Zwischen minus 60° C und minus 40° C lässt man 18 Stunden lang polymerisieren. Die viskose Lösung wird in 1 l Methanol ausgefällt. Das weisse Polymerpulver wird getrocknet und in 100 ml THF gelöst, filtriert und erneut in 1 l Methanol ausgefällt. Man trennt das Polymer ab, lässt an der Luft trockensaugen und trocknet am Hochvakuum bei 50° C. Ausbeute: 6,1 g weisses Polymerpulver (31 %).

| Elementaranalyse: | berechnet | gefunden |
|---|---|---|
| % C | 61,66 | 61,60 |
| % H | 8,63 | 8,62 |
| % Si | 16,02 | 16,03 |

GPC (THF):
$\overline{M}_n$ = 52 000
$\overline{M}_w$ = 102 000

Thermogravimetrische Analyse:

Das Polymer zerfällt bei 170°C in $CO_2$ und 1,1-Bistrimethylsilylethen.

Beispiel 10:

Herstellung von 4-(2′-Trimethylsilyl-2′propoxycarbonyloxy)-α-methylstyrol durch Umsetzung von 2-Trimethylsilyl-2-propanol mit 4-Chlorformyloxy-α-methylstyrol

In einem 250 ml Dreihalskolben mit Tropftrichter und Thermometer werden 10 g (75,6 mmol) 2-Trimethylsilyl-2-propanol und 7,2 g (91 mmol) Pyridin in 100 ml wasserfreiem Methylenchlorid gelöst. Nachdem man die Lösung auf 0°C abgekühlt hat, tropft man 17,8 g (90,5 mmol) 4-Chlorformyloxy-α-methylstyrol (hergestellt gemäss Beispiel 6.2 der DE-OS 25 08 512) dazu. Nach dem Zutropfen lässt man auf Raumtemperatur erwärmen und rührt die Suspension noch eine Stunde lang nach. Das entstandene Pyridinhydrochlorid wird abgetrennt und die organische Phase je zweimal mit 1N HCl, Wasser und gesättigter Natriumbicarbonatlösung gründlich gewaschen. Dann wird mit Natriumsulfat getrocknet und am Rotationsverdampfer eingeengt. Das flüssige Produkt wird über eine Kieselgelsäule mit Toluol als Laufmittel gereinigt. Man erhält 14 g (40 mmol, 63 % Ausbeute) 4-(2′-Trimethylsilyl-2′-propoxycarbonyloxy)-α-methylstyrol, dessen Eigenschaften identisch mit der unter Beispiel 3 beschriebenen Substanz sind.

ANWENDUNGSBEISPIELE

Beispiel A1:

Zu einer 10 Gew.%igen Lösung des Polymers gemäss Beispiel 4 in Cyclohexanon werden 10 Gew.-% 4-Phenylthiophenyldiphenylsulfonium-Hexafluorarsenat [hergestellt gemäss J. Polymer Sci., Polymer Chem. Ed., 18, 2677-2695 (1980)], bezogen auf das Polymer, gegeben. Diese Lösung wird durch ein 0,5 Mikronfilter auf einen Silizium-Wafer getropft und mittels Schleuderbeschichtung (spin coating) wird ein homogener Film erzeugt. Der Polymerfilm wird bei 90°C während 20 Minuten getrocknet. Die Schichtdicke des amorphen, homogenen Films beträgt 0,5 µm. Durch eine Chrom-Quarzmaske wird der Film bei 254 nm mit einer Dosis von 1-2 $mJ/cm^2$ belichtet. Das belichtete Material wird anschliessend bei 90°C 10 Minuten lang entwickelt. Deutlich ist das hoch aufgelöste Maskenmuster zu erkennen. Die belichteten Zonen werden in einer RIE-Apparatur (Reactive Ion Etching) mit Sauerstoffplasma unter anisotropen Bedingungen ($O_2$-Fluss: 20 sccm/min, Druck: $4 \cdot 10^{-2}$ mbar, 35 Watt) freigeätzt, während die nicht belichteten Zonen nicht angegriffen werden. Messungen ergaben, dass belichtete Zonen etwa 30 mal schneller abgeätzt werden als nichtbelichtete Zonen. Mit dieser Technik gelingt es, selbst Submikronstrukturen im Resist trocken zu entwickeln.

Beispiel A2:

Zu einer 10 Gew.%igen Lösung des Polymers gemäss Beispiel 5 in Cyclohexanon werden 5 Gew.% Diphenyljodonium-Trifluormethansulfonat (hergestellt gemäss der DE-OS 27 31 396, Beispiel 4), bezogen auf das Polymer, gegeben. Die Lösung wird wie in Beispiel A1 beschrieben auf einen Silicium-Wafer aufgetragen und ein 0,7 µm dicker Resistfilm wird erzeugt. Der Film wird durch eine Chrom-Quarzmaske bei 254 nm mit einer Dosis von 4 $mJ/cm^2$ belichtet und anschliessend bei 90°C während 10 Minuten entwickelt. Das in den belichteten Zonen gebildete Poly(4-Hydroxy)-α-methylstyrol] wird mit einem wässrig-alkalischen Entwickler enthaltend 1 Teil Microposit MF 315® (der Fa. Shipley Co. Inc., Newton, MA, U.S.A.) 1 Teil deionisiertes Wasser und 1 Teil Isopropanol herausgelöst, während die nichtbelichteten Zonen vom basischen Entwickler nicht angegriffen werden. Damit gelingt es, quellungsfreie Muster mit hoher Auflösung im Resistfilm zu erzeugen.

Beispiel A3:

Zu einer 10 Gew.%igen Lösung des Polymers gemäss Beispiel 5 in Cyclohexanon werden 5 Gew.%, bezogen auf das Polymer, 4-Phenylthiophenyldiphenylsulfonium-Hexafluorarsenat gegeben. Die Lösung wird wie im Beispiel A1 beschrieben auf eine 2,3 µm dicke, vernetzte Polyimidschicht (Probimid® 284 der Ciba-Geigy AG) aufgetragen und ein 0,7 µm dicker Resistfilm wird erzeugt. Der Film wird durch eine Chrom-Quarzmaske bei 254 nm mit einer Dosis von 10 $mJ/cm^2$ belichtet und anschliessend bei 100°C während 30 Minuten entwickelt. Die belichteten, vom Silicium befreiten Zonen werden in einer RIE-Apparatur unter anisotropen Bedingungen (Plasmafluss: 20 sccm/min; Gase: während einer Minute $CF_4$, dann $O_2$; Druck $4 \cdot 10^{-2}$ mbar, 35 Watt) zusammen mit der darunterliegenden Polyiimidschicht weggeätzt, während die unbelichteten Zonen plasmaresistent sind.

**Patentansprüche**

1. Organometallhaltige Polymere mit Gruppierungen der Formel I

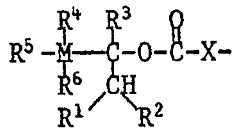

(I) ,

worin $R^1$ bis $R^6$ unabhängig voneinander $C_1$-$C_4$-Alkyl, $C_1$-$C_4$-Alkoxy, Phenyl, Benzyl, Phenoxy, eine Gruppe -$M(R^8)_3$ oder

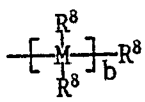

bedeuten oder $R^3$ und $R^4$ zuzammen für

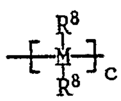

stehen und $R^1$ bis $R^3$ zusätzlich auch Wasserstoffatome sein können, $R^8$ $C_1$-$C_4$-Alkyl, $C_1$-$C_4$-Alkoxy, Phenyl, Benzyl oder Phenoxy ist, M für Si, Ge, Sn, $CH_2Si$ oder OSi und X für O, S oder NR′ mit R′ gleich Wasserstoff oder einfache Bindung stehen, b eine ganze Zahl von 1 bis 6 und c eine ganze Zahl von 3 bis 6 bedeuten, und einem mittleren Molekulargewicht zwischen 1000 und 1'000'000.

2. Polymere nach Anspruch 1, worin M $CH_2Si$, OSi oder Si bedeutet.

3. Polymere nach Anspruch 1, worin X S oder O bedeutet.

4. Polymere nach Anspruch 1, worin $R^1$ und $R^2$ je Wasserstoff, $R^3$ Methyl oder $Si(CH_3)_3$ und $R^4$ bis $R^6$ je Methyl bedeuten oder worin $R^3$ und $R^4$ zusammen für

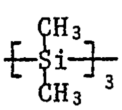 oder 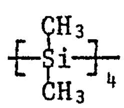

stehen.

5. Polymere nach Anspruch 1, worin $R^1$ und $R^2$ je Wasserstoff, $R^3$ Methyl oder $Si(CH_3)_3$, $R^4$ bis $R^6$ je Methyl, M Si und X O bedeuten.

6. Polymere nach Anspruch 1 mit wiederkehrenden Einheiten der Formel II

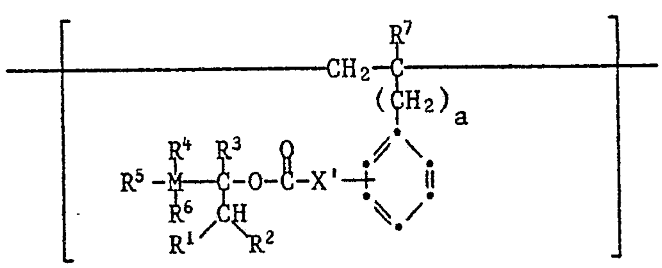

(II) ,

worin $R^1$ bis $R^6$ und M die im Anspruch 1 angegebene Bedeutung haben, X′ für O, S oder NH steht, $R^7$ Wasserstoff oder $C_1$-$C_4$-Alkyl und a Null oder 1 bedeuten.

7. Polymere nach Anspruch 6, worin a Null und $R^7$ Wasserstoff oder Methyl bedeuten.

8. Organometallhaltige Copolymere, welche neben den Strukturelementen der Formel II nach Anspruch 6 bis zu 50 Mol%, bezogen auf das gesamte Copolymer, Struktureinheiten enthalten, welche sich von anderen copolymerisierbaren Monomeren ableiten.

9. Copolymer nach Anspruch 8, welche neben den Strukturelementen der Formel II mindestens eines der Strukturelemente der Formeln III oder IV enthalten

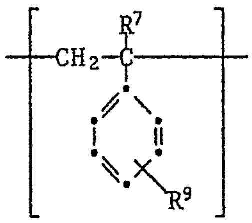 (III) 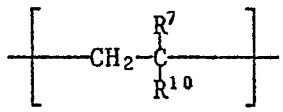 (IV) ,

worin $R^7$ die im Anspruch 6 angegebene Bedeutung hat, $R^9$ für Wasserstoff, $C_1$-$C_4$-Alkyl oder $C_1$-$C_4$-Alkoxy und $R^{10}$ für Wasserstoff, $C_1$-$C_4$-Alkyl, $C_1$-$C_4$-Alkoxy, $C_1$-$C_4$-Alkoxycarbonyl oder $C_1$-$C_4$-Alkylcarbonyloxy stehen.

10. Polymere nach Anspruch 1, worin die Gruppierungen der Formel I direkt oder über eine Gruppe der Formel V

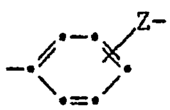 (V),

worin Z O, S oder NR′ mit R′ gleich Wasserstoff oder einfache Bindung bedeutet, an einen Polyalkohol, ein Polyphenol, ein Polythiol, ein Polyamin, oder ein Polyimid gebunden sind.

11. Zusammensetzung enthaltend ein Polymer nach den Ansprüchen 1 oder 8 und eine unter Einwirkung von Strahlung eine Säure freisetzende Verbindung.

12. Verwendung der Zusammensetzung nach Anspruch 11 zur Herstellung von strukturierten Positivbildern.

13. Substrat beschichtet mit einer Zusammensetzung nach Anspruch 11.